# EUROPEAN PATENT APPLICATION

(11) **EP 4 254 066 A1**
(43) Date of publication of application: **04.10.2023**
(21) Application number: 21898179.3
(22) Date of filing: 30.11.2021
(51) Int. Cl.: G03F 7/00, G03F 7/32

(54) **AQUEOUS DEVELOPER FOR FLEXOGRAPHIC PRINTING PLATE, AND METHOD FOR PRODUCING FLEXOGRAPHIC PRINTING PLATE**

(30) Priority: 30.11.2020 JP 2020198053
(71) Applicant: FUJIFILM Corporation, Tokyo 106-8620 (JP)
(72) Inventor: SHIRAKAWA, Masato, Haibara-gun, Shizuoka 421-0396 (JP)
(74) Representative: HGF
(86) International application number: PCT/JP2021/043759
(87) International publication number: WO 2022/114208

(57) **Abstract**

An object of the present invention is to provide an aqueous developer for a flexographic printing plate capable of maintaining excellent development scum dispersibility and improving brush contamination, and a manufacturing method of a flexographic printing plate using the same. The aqueous developer for a flexographic printing plate of the present invention is an aqueous developer for a flexographic printing plate, containing a surfactant represented by Formula (1), a surfactant represented by Formula (2), and water.

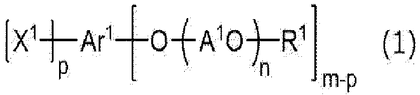

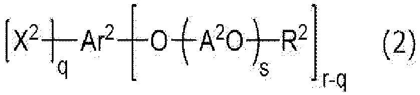

## Description

### BACKGROUND OF THE INVENTION

### 1. Field of the Invention

The present invention relates to an aqueous developer for a flexographic printing plate and a manufacturing method of a flexographic printing plate using the same.

### 2. Description of the Related Art

In recent years, various industries have started to reduce the use of organic solvents from the viewpoint of improving the working environment and preserving the global environment, and in a plate making step of a photosensitive flexographic printing plate used for printing, the use of an aqueous developable photosensitive resin plate is increasing.

For example, WO2020/209143A discloses "an aqueous developer for a flexographic printing plate, containing a surfactant represented by Formula (1) and water, 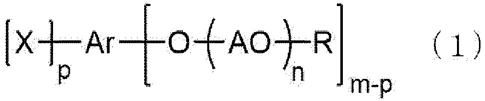 here, in Formula (1),
Ar represents an m-valent aromatic group and m represents an integer of 1 to 8,
X represents a monovalent organic group and p represents an integer of 0 to 3, which is smaller than m, in a case where p is 2 or 3, a plurality of X's may be the same or different from each other,
A represents an alkylene group having 2 to 4 carbon atoms, R represents a hydrogen atom or an anionic group, and n represents an integer of 1 to 100, in a case where n is an integer of 2 to 100, a plurality of A's may be the same or different from each other, and in a case where m - p is an integer of 2 to 6, a plurality of A's, n's, and R's may all be the same or different from each other" ([claim 1]).

### SUMMARY OF THE INVENTION

In a study of an aqueous developer disclosed in WO2020/209143A, the present inventors have found that, after repeated use, aggregation of dispersion in the developer diluted with water can be suppressed (hereinafter, also abbreviated as "excellent in development scum dispersibility"), but it has been clarified that there is room for improvement in stains on a brush used in a development step (hereinafter, also abbreviated as "brush contamination").

An object of the present invention is to provide an aqueous developer for a flexographic printing plate capable of maintaining excellent development scum dispersibility and improving brush contamination, and a manufacturing method of a flexographic printing plate using the same.

As a result of conducting intensive investigations to achieve the above-described object, the present inventors have found that an aqueous developer formulating two types of surfactants having specific structures can maintain excellent development scum dispersibility and improve brush contamination, and thus completed the present invention.

That is, the present inventors have found that the above-described object can be achieved by adopting the following configurations.
[1] An aqueous developer for a flexographic printing plate, comprising:
   a surfactant represented by Formula (1) described later;
   a surfactant represented by Formula (2) described later; and
   water.
[2] The aqueous developer for a flexographic printing plate according to [1],
   in which a content of the surfactant represented by Formula (1) described later is more than 15% by mass and less than 85% by mass with respect to a total content of the surfactant represented by Formula (1) described later and the surfactant represented by Formula (2) described later.
[3] The aqueous developer for a flexographic printing plate according to [1] or [2],
   in which an anionic group represented by R² in Formula (2) described later is an oxoacid group or an oxoacid salt group.
[4] The aqueous developer for a flexographic printing plate according to [3],
   in which the oxoacid salt group is an ammonium salt, a primary ammonium salt, a secondary ammonium salt, a tertiary ammonium salt, or a quaternary ammonium salt of the oxoacid group.
[5] The aqueous developer for a flexographic printing plate according to any one of [1] to [4],
   in which an anionic group represented by R² in Formula (2) described later is a phosphoric acid group or a phosphoric acid salt group.
[6] The aqueous developer for a flexographic printing plate according to any one of [1] to [5], further comprising:
   an alkali agent.
[7] The aqueous developer for a flexographic printing plate according to any one of [1] to [6], further comprising:
   an antifoaming agent.
[8] The aqueous developer for a flexographic printing plate according to any one of [1] to [7], further comprising:
   a chelating agent.
[9] The aqueous developer for a flexographic printing plate according to any one of [1] to [8],
   in which a concentration of divalent metal ions is 20 ppm or less in terms of calcium carbonate.
[10] A manufacturing method of a flexographic printing plate having a non-image area and an image area, the manufacturing method comprising:
   an exposure step of imagewise exposing a photosensitive layer in a flexographic printing plate precursor having the photosensitive layer;
   a development step of, after the exposure step, performing development using the aqueous developer for a flexographic printing plate according to any one of [1] to [9] to form a non-image area and an image area; and
   a rinse step of, after the development step, performing rinsing with water.
[11] The manufacturing method of a flexographic printing plate according to [10],
   in which the water used in the rinse step is water in which a concentration of divalent metal ions is 20 ppm or less in terms of calcium carbonate.
[12] The manufacturing method of a flexographic printing plate according to [10] or [11],
   in which the aqueous developer for a flexographic printing plate used in the development step is a used developer obtained by using the aqueous developer for a flexographic printing plate according to any one of [1] to [9] for one or more developments, and
   the manufacturing method further includes a step of replenishing the aqueous developer for a flexographic printing plate according to any one of [1] to [9] such that a concentration of components of the photosensitive layer, which have been removed by the development and which is contained in the used developer, is maintained to 7% or less.

According to the present invention, it is possible to provide an aqueous developer for a flexographic printing plate capable of maintaining excellent development scum dispersibility and improving brush contamination, and a manufacturing method of a flexographic printing plate using the same.

### BRIEF DESCRIPTION OF THE DRAWINGS

Fig. 1 is a schematic cross-sectional view of an evaluation device for brush contamination.
Fig. 2 is a layout diagram of bristles in a brush of the evaluation device.

### DESCRIPTION OF THE PREFERRED EMBODIMENTS

Hereinafter, the present invention will be described in detail.

The description of configuration requirements described below may be made on the basis of representative embodiments of the present invention, but it should not be construed that the present invention is limited to those embodiments.

In the specification of the present application, the numerical range expressed by using "to" means a range including the numerical values before and after "to" as the lower limit value and the upper limit value.

In addition, in this specification, for each component, one kind of substance corresponding to each component may be used alone, or two or more kinds thereof may be used in combination. Here, in a case where two or more kinds of substances are used in combination for each component, the content of the component indicates the total content of the substances used in combination, unless otherwise specified.

### [Aqueous developer for flexographic printing plate]

The aqueous developer for a flexographic printing plate according to the embodiment of the present invention (hereinafter, also abbreviated as "aqueous developer according to the embodiment of the present invention") is an aqueous developer for a flexographic printing plate, which contains a surfactant represented by Formula (1) (hereinafter, also abbreviated as "surfactant (1)"), a surfactant represented by Formula (2) (hereinafter, also abbreviated as "surfactant (2)"), and water. Description of each symbol in Formulae (1) and (2) will be described later.

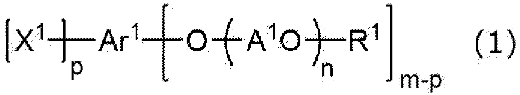

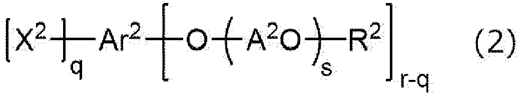

In the present invention, as described above, the aqueous developer formulating the surfactant (1) and the surfactant (2) can maintain excellent development scum dispersibility and improve brush contamination.

Although the details thereof are not clear, the present inventors have presumed as follows.

First, as shown in Comparative Example 2 described later, in a case of an aqueous developer formulating only the surfactant (1), it could be seen that the development scum dispersibility was excellent, but there is room for improvement in brush contamination. It is presumed that this is because a hydrophilic portion is not sufficiently hydrophilic and a sufficient amount of water film cannot be retained on a surface of development scum (rubber) particles, so that a fatigue solution remaining on the brush easily evaporates and adheres to the brush portion.

In addition, as shown in Comparative Example 3 described later, even in a case of an aqueous developer formulating only the surfactant (2), it could be seen that the development scum dispersibility was excellent, but there is room for improvement in brush contamination. It is presumed that this is because the hydrophilic portion is highly hydrophilic and the surfactant on the surface of development scum (rubber) particles is easily detached, so that the development scum sticks to the brush in a case where the rubber surface is exposed.

Therefore, in the present invention, by formulating the surfactant (1) and the surfactant (2), the detachment of the surfactant associated with the surface of development scum (rubber) particles is suppressed and a sufficient amount of water film can be retained. Accordingly, it is considered that excellent development scum dispersibility can be maintained and the brush contamination can be improved.

Hereinafter, each component contained in the aqueous developer according to the embodiment of the present invention will be described in detail.

### [Surfactant (1)]

The surfactant (1) contained in the aqueous developer according to the embodiment of the present invention is a surfactant represented by Formula (1).

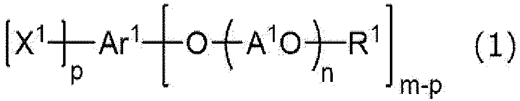

In Formula (1), Ar¹ represents an m-valent aromatic group and m represents an integer of 1 to 8.

In addition, X¹ represents a monovalent organic group and p represents an integer of 0 to 3, which is smaller than m. In a case where p is 2 or 3, a plurality of X¹'s may be the same or different from each other.

In addition, A¹ represents an alkylene group having 2 to 4 carbon atoms, R¹ represents a hydrogen atom or an alkyl group, and n represents an integer of 1 to 100. In a case where n is an integer of 2 to 100, a plurality of A¹'s may be the same or different from each other. In a case where m - p is an integer of 2 to 8, a plurality of A¹'s, n's, and R¹'s may all be the same or different from each other.

The aromatic group represented by Ar¹ in Formula (1) refers to a group which includes a ring having aromaticity, and examples thereof include m-valent groups having at least one aromatic ring selected from the group consisting of an aromatic hydrocarbon ring and an aromatic heterocyclic ring.

Here, examples of the aromatic hydrocarbon ring include a benzene ring, a naphthalene ring, an anthracene ring, and a phenanthroline ring, and examples of the aromatic heterocyclic ring include a furan ring, a pyrrole ring, a thiophene ring, a pyridine ring, a thiazole ring, and a benzothiazole ring.

In addition, the valence (m) of the aromatic group represented by Ar¹ in Formula (1) is an integer of 1 to 8, preferably an integer of 2 to 6, more preferably an integer of 2 to 4, and still more preferably 2 or 3.

Among these, as Ar¹, a divalent benzene ring (that is, a phenylene group) or a monovalent naphthalene ring (that is, a naphthyl group) is preferable, and a phenylene group is more preferable.

Examples of the monovalent organic group represented by X¹ in Formula (1) include an alkyl group, a cycloalkyl group, an aryl group, an aralkyl group, and an alkenyl group, and these groups may further have a substituent.

Examples of the alkyl group include a linear or branched alkyl group having 1 to 18 carbon atoms, and specific examples thereof include a methyl group, an ethyl group, a propyl group, a butyl group, a pentyl group, a tert-pentyl group, and an n-hexyl group.

Examples of the cycloalkyl group include a monocyclic or polycyclic cycloalkyl group having 3 to 20 carbon atoms, and specific examples thereof include a cyclopentyl group, a cyclopentylmethyl group, a cyclopentylethyl group, a cyclohexyl group, a cyclohexylmethyl group, and a cyclohexylethyl group.

Examples of the aryl group include an aryl group having 6 to 14 carbon atoms, and specific examples thereof include a phenyl group, a methylphenyl group, a tolyl group, a xylyl group, a naphthyl group, an anthryl group, a phenanthryl group, and a pyrenyl group.

Examples of the aralkyl group include an aralkyl group having 7 to 20 carbon atoms, and specific examples thereof include a benzyl group, a phenethyl group, a 2-phenylethan-2-yl group, and a naphthylmethyl group.

Examples of the alkenyl group include an alkenyl group having 3 to 20 carbon atoms, and specific examples thereof include a vinyl group and an allyl group.

Among these organic groups, from the reason that the dispersibility of development scum is improved, X¹ in Formula (1) is preferably an aralkyl group and more preferably a 2-phenylethan-2-yl group or a benzyl group.

Structures of the 2-phenylethan-2-yl group and the benzyl group are as shown in Formulae (X-1) and (X-2) described below, and the structure represented by Formula (X-1) (2-phenylethan-2-yl group) is also referred to as "styrenated" or "styryl group".

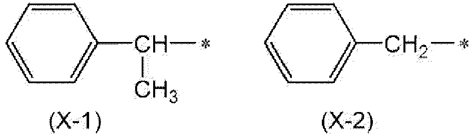

p in Formula (1) represents an integer of 0 to 3, which is smaller than m, and from the reason that the dispersibility of development scum is improved, p preferably represents an integer of 1 to 3 and more preferably represents 1 or 2.

m - p in Formula (1) is preferably an integer of 1 to 3, more preferably 1 or 2, and still more preferably 1.

A¹ in Formula (1) represents an alkylene group having 2 to 4 carbon atoms, and is preferably an alkylene group having 2 or 3 carbon atoms and more preferably an ethylene group or an n-propylene group.

As the alkyl group which represents one aspect of R¹ in Formula (1), an alkyl group having 1 to 6 carbon atoms is preferable, and an alkyl group having 1 to 4 carbon atoms is more preferable. Specific examples thereof include a methyl group, an ethyl group, a propyl group, and an n-butyl group.

R¹ in Formula (1) represents a hydrogen atom or an alkyl group, and from the reason that the dispersibility of development scum is improved, R¹ is preferably a hydrogen atom.

n in Formula (1) represents an integer of 1 to 100, and from the reason that the dispersibility of development scum is improved, n is preferably an integer of 1 to 30, more preferably an integer of 5 to 20, and still more preferably an integer of 5 to 15.

Specific examples of the surfactant represented by Formula (1) (nonionic surfactant) include:
polyoxyalkylene polystyrylphenyl ethers such as polyoxyethylene styrenated phenyl ether, polyoxyethylene polystyrylphenyl ether, polyoxyethylene distyrenated phenyl ether, polyoxyethylene tristylylphenyl ether represented by Formula (1-1), polyoxyethylene styrenated phenyl ether ammonium sulfate, and polyoxyethylene polystyrylphenyl ether condensate; and
polyoxyethylene dodecylphenyl ether, polyoxyethylene phenyl ether, polyoxyethylene benzyl ether, polyoxyethylene β-naphthyl ether, polyoxyethylene bisphenol A ether, polyoxyethylene bisphenol F ether, polyoxyethylene cumylphenyl ether, polyoxyethylene naphthyl ether, polyoxyethylene tribenzylphenyl ether, polyoxyethylene aryl ether, polyoxyethylene polycyclic phenyl ether, and polyoxyalkylene polycyclic phenyl ether.

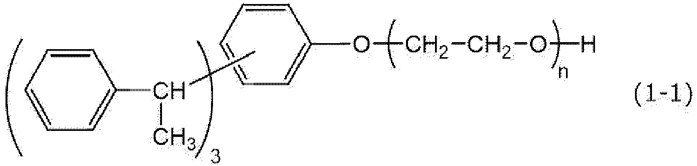

In the present invention, a content of the surfactant (1) is preferably 0.01% to 10% by mass and more preferably 0.1% to 2% by mass with respect to the total mass of the aqueous developer according to the embodiment of the present invention.

### [Surfactant (2)]

The surfactant (2) contained in the aqueous developer according to the embodiment of the present invention is a surfactant represented by Formula (2).

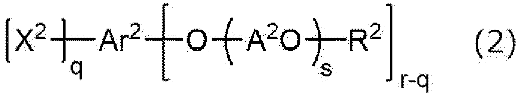

In Formula (2), Ar² represents an r-valent aromatic group and r represents an integer of 1 to 8.

In addition, X² represents a monovalent organic group and q represents an integer of 0 to 3, which is smaller than r. In a case where q is 2 or 3, a plurality of X²'s may be the same or different from each other.

In addition, A² represents an alkylene group having 2 to 4 carbon atoms, R² represents an anionic group, and s represents an integer of 1 to 100. In a case where s is an integer of 2 to 100, a plurality of A²'s may be the same or different from each other. In a case where r - q is an integer of 2 to 8, a plurality of A²'s, s's, and R²'s may all be the same or different from each other.

Ar², r, X², q, A², and s in Formula (2) are respectively the same as Ar¹, m, X¹, p, A¹, and n described for Formula (1) above, and suitable aspects thereof are also the same.

From the viewpoint of environmental safety, the anionic group represented by R² in Formula (2) is preferably an oxoacid group or an oxoacid salt group.

Here, examples of the oxoacid group include a carboxylic acid group, a phosphoric acid group, a phosphonic acid group, a sulfonic acid group, and a sulfuric acid group.

In the present invention, from the reason that the brush contamination can be further improved, the oxoacid salt group is preferably an ammonium salt, a primary ammonium salt, a secondary ammonium salt, a tertiary ammonium salt, or a quaternary ammonium salt of the oxoacid group.

In addition, in the present invention, from the reason that the brush contamination can be further improved, it is preferable that the anionic group represented by R² in Formula (2) is a phosphoric acid group or a phosphoric acid salt group.

Specific examples of the surfactant represented by Formula (2) (anionic surfactant) include a triethanolamine salt of polyoxyethylene allylphenyl ether phosphate, an ammonium salt of polyoxyethylene allylphenyl ether phosphate, polyoxyethylene allylphenyl ether phosphate, a potassium salt of polyoxyethylene allylphenyl ether phosphate, and polyoxyethylene allylphenyl ether sulfate.

In the present invention, a content of the surfactant (2) is preferably 0.01% to 5% by mass and more preferably 0.1% to 1% by mass with respect to the total mass of the aqueous developer according to the embodiment of the present invention.

In the present invention, from the reason that the brush contamination can be further improved, the content of the surfactant (1) represented by Formula (1) is preferably 15% by mass and less than 85% by mass, more preferably more than 50% by mass and less than 80% by mass, and still more preferably 55% to 65% by mass with respect to the total content of the surfactant (1) and the surfactant (2).

### [Water]

The water contained in the aqueous developer according to the embodiment of the present invention is not particularly limited, and any of purified water, distilled water, ion exchange water, pure water, ultrapure water such as Milli-Q water can be used. The Milli-Q water is ultrapure water obtained by a Milli-Q water production device, which is an ultrapure water production device manufactured by Merck KGaA.

A content of water contained in the aqueous developer according to the embodiment of the present invention is preferably 80% to 99.99% by mass and more preferably 90% to 99.9% by mass with respect to the total mass of the aqueous developer.

### [Alkali agent]

From the reason that the developability is good, it is preferable that the aqueous developer according to the embodiment of the present invention contains an alkali agent.

Examples of the alkali agent include an alkali metal carbonate and an alkali metal hydroxide.

Here, specific examples of the alkali metal include sodium, potassium, and calcium.

In addition, specific examples of the alkali metal carbonate include sodium carbonate, and potassium carbonate, and among these, sodium carbonate is preferable from the viewpoint of safety.

In addition, specific examples of the alkali metal hydroxide include sodium hydroxide and potassium hydroxide.

A content of the alkali agent in a case of being contained is preferably 0.01% to 5% by mass and more preferably 0.1% to 1% by mass with respect to the total mass of the aqueous developer.

### [Chelating agent]

From the reason that the dispersibility of development scum can be improved and the brush contamination can be further improved, the aqueous developer according to the embodiment of the present invention preferably contains a chelating agent.

Specific examples of the chelating agent include citric acid, ethylenediaminetetraacetic acid (EDTA), ethylenediamine-N,N'-disuccinic acid (EDDS), L-glutamate diacetic acid (GLDA), and an alkali metal salt thereof.

### [Antifoaming agent]

From the reason that the brush contamination can be further improved, the aqueous developer according to the embodiment of the present invention preferably contains an antifoaming agent.

Specific examples of the antifoaming agent include lower alcohol-based antifoaming agents such as methanol, ethanol, and butanol; silicone-based antifoaming agents; mineral oil-based antifoaming agents; organic polar compound-based antifoaming agents such as tributyl phosphate and oleic acid; and polyether-based antifoaming agents such as a polypropylene glycol derivative.

### [Other components]

In the aqueous developer according to the embodiment of the present invention, various additives may be formulated as optional components, as required.

Examples of the additives include alkanolamine such as ethanolamine; preservatives such as benzotriazole and benzoic acid; and freezing point depressants such as glycols (for example, ethylene glycol) and lower alcohols (for example, ethanol), and these can be appropriately formulated within a range which does not impair the effects of the present invention.

In the aqueous developer according to the embodiment of the present invention, from the reason that the dispersibility of development scum can be improved and the brush contamination can be further improved, it is preferable that a concentration of divalent metal ions is 20 ppm or less in terms of calcium carbonate.

Here, the conversion of calcium carbonate is an U.S. water hardness, that is, a value obtained by converting the total concentration of calcium ions and magnesium ions into calcium carbonate, and is expressed in mg/L as a unit.

In addition, the concentration of divalent metal ions can be adjusted by using, as the water described above, water from which so-called hard water components such as calcium and magnesium have been removed by a water softening device.

As the water softening device, an ion exchange resin-type water softening device or a reverse osmosis membrane-type water softening device can be used. As the water softening device, Kurisofner KS-MA-12J (manufactured by Kurita Water Industries Ltd.), which is an ion exchange resin-type, is preferable from the viewpoint of performance, price, and maintainability.

### [Development method]

As a development method using the aqueous developer according to the embodiment of the present invention, the same method as a development method using a known aqueous developer in the related art may be used, and examples thereof include a method of bringing an aqueous developer into contact with a non-exposed portion of a flexographic printing plate precursor, applying a physical action of a brush, water pressure, supersonic waves, or the like, and dispersing a photosensitive layer (photosensitive resin composition) that constitutes the non-exposed portion in the aqueous developer to remove the photosensitive layer.

In this case, the non-exposed portion may be immersed in the aqueous developer, or the aqueous developer may be continuously supplied and brought into contact with the non-exposed portion in a case where a physical action is exerted.

In addition, the liquid temperature of the aqueous developer during development is preferably 20°C to 60°C and more preferably 30°C to 50°C.

In addition, a brush is used for the physical action force usually used, and the material, thickness, and length of bristles, denseness and arrangement of bristles, movement and rotation direction of brush, and the like are appropriately selected.

### [Flexographic printing plate precursor]

For the photosensitive layer (photosensitive resin composition) of the flexographic printing plate precursor developed with the water developer according to the embodiment of the present invention, a known photosensitive resin composition in the related art can be used. Examples thereof include a resin composition containing a water-dispersible latex, rubber, a photopolymerizable monomer, a photopolymerization initiator, and a surfactant.

### <Water-dispersible latex>

The water-dispersible latex contained in the resin composition is not particularly limited, and water-dispersible latexes used in a known flexographic printing plate in the related art can be used.

Specific examples of the water-dispersible latex include water-dispersible latex polymers such as polybutadiene latex, natural rubber latex, styrene-butadiene copolymer latex, acrylonitrile-butadiene copolymer latex, polychloroprene latex, polyisoprene latex, polyurethane latex, methylmethacrylate-butadiene copolymer latex, vinylpyridine polymer latex, butyl polymer latex, Thiokol polymer latex, and acrylate polymer latex; and polymers obtained by copolymerizing another component, such as acrylic acid and methacrylic acid, therewith. These may be used alone or in combination of two or more.

### <Rubber>

The rubber contained in the resin composition is not particularly limited, and rubber materials used in a known flexographic printing plate in the related art can be used.

Specific examples of the rubber include butadiene rubber (BR), nitrile rubber (NBR), acrylic rubber, epichlorohydrin rubber, urethane rubber, isoprene rubber, styrene isoprene rubber, styrene butadiene rubber, ethylene-propylene copolymer, and chlorinated polyethylene. These may be used alone or in combination of two or more.

### <Photopolymerizable monomer>

The photopolymerizable monomer contained in the resin composition is not particularly limited, and photopolymerizable monomers used in a known flexographic printing plate in the related art can be used.

Examples of the photopolymerizable monomer include ethylenically unsaturated compounds.

Specific examples of the ethylenically unsaturated compound include (meth)acrylic monomers, (meth)acrylic oligomers, and (meth)acrylic modified polymers.

In addition, specific examples of the (meth)acrylic modified polymer include (meth)acrylic modified butadiene rubber and (meth)acrylic modified nitrile rubber.

The term "(meth)acrylic" is a notation meaning acrylic or methacrylic.

### <Photopolymerization initiator>

The photopolymerization initiator contained in the resin composition is not particularly limited as long as the photopolymerization of the above-described photopolymerizable monomer is initiated, and examples thereof include photopolymerization initiators such as alkylphenones, acetophenones, benzoin ethers, benzophenones, thioxanthones, anthraquinones, benzyls, and biacetyls.

Specific examples thereof include benzyl dimethyl ketal, 2-hydroxy-2-methyl-1-phenyl-propane-1-one, methyl-o-benzoylbenzoate, and 1-hydroxycyclohexyl phenyl ketone.

### <Surfactant>

From the viewpoint of improving water developability, the resin composition contained in the resin composition preferably contains a surfactant.

Examples of the surfactant include a cationic surfactant, an anionic surfactant, and a nonionic surfactant. Among these, an anionic surfactant is preferable.

Specific examples of the anionic surfactant include
aliphatic carboxylates such as sodium laurate, and sodium oleate;
higher alcohol sulfate salts such as sodium lauryl sulfate, sodium cetyl sulfate, and sodium oleyl sulfate;
polyoxyethylene alkyl ether sulfate ester salts such as sodium polyoxyethylene lauryl ether sulfate;
polyoxyethylene alkyl allyl ether sulfate ester salts such as sodium polyoxyethylene octyl phenyl ether sulfate and sodium polyoxyethylene nonyl phenyl ether sulfate;
alkyl sulfonates such as alkyl diphenyl ether disulfonate, sodium dodecyl sulfonate, and sodium dialkyl sulfosuccinate;
alkyl allyl sulfonates such as alkyl disulfonate, sodium dodecyl benzene sulfonate, sodium dibutyl naphthalene sulfonate, and sodium triisopropyl naphthalene sulfonate;
higher alcohol phosphate ester salts such as disodium lauryl phosphate monoester, and sodium lauryl phosphate diester; and
polyoxyethylene alkyl ether phosphate ester salts such as disodium polyoxyethylene lauryl ether phosphate monoester, and sodium polyoxyethylene lauryl ether phosphate diester.

These may be used alone or in combination of two or more.

### [Manufacturing method of flexographic printing plate]

A manufacturing method of a flexographic printing plate according to an embodiment of the present invention includes an exposure step of imagewise exposing a photosensitive layer in a flexographic printing plate precursor having the photosensitive layer, a development step of, after the exposure step, performing development using the aqueous developer for a flexographic printing plate to form a non-image area and an image area, and a rinse step of, after the development step, performing rinsing with water.

### [Exposure step]

The exposure step is a step of imagewise irradiating the photosensitive layer with an actinic ray to induce crosslinking and/or polymerization of a region irradiated with the actinic ray and to cure the region.

The above-described exposure step can be performed by exposing the photosensitive layer through a mask provided on an outer surface side of the photosensitive layer.

In addition, it is also preferable to perform the exposure using a vacuum frame exposure device, and in this case, after the air between a relief forming layer and the mask is exhausted, the exposure with an actinic ray is performed.

In addition, the exposure may be performed in a state in which the oxygen concentration is lowered, or may be performed in the atmosphere. Although not particularly limited, from the viewpoint of preventing polymerization inhibition by oxygen, it is preferable that the exposure is performed at a low oxygen concentration.

### [Development step]

The development step is a step of performing developing using the above-described aqueous developer according to the embodiment of the present invention to form a non-image area and an image area, and the details are as described in the above-mentioned development method of the aqueous developer according to the embodiment of the present invention.

### [Rinse step]

The rinse step is a step of rinsing surfaces of the non-image area and the image area formed in the development step with water.

In the present invention, since the developer remaining on the surfaces of the non-image area and the image area is the above-described aqueous developer according to the embodiment of the present invention, even in a case where the aqueous developer is diluted with water used in the rinse step, adhesion and aggregation of the development scum in the developer can be suppressed.

In the present invention, from the reason that the dispersibility of development scum is improved, it is preferable that the water used in the above-described rinse step is water in which a concentration of divalent metal ions is 20 ppm or less in terms of calcium carbonate. Therefore, as the water used in the above-described rinse step, it is preferable to use water from which so-called hard water components such as calcium and magnesium have been removed by a water softening device.

As a rinsing method in the rinse step, a method of washing with tap water, a method of spraying high pressure water, a method of rubbing the surfaces of the non-image area and the image area with a brush using a batch-type or transport-type brush type washing machine as a developing machine for flexographic printing plates mainly in the presence of water, and the like may be used.

In the manufacturing method of a flexographic printing plate according to an embodiment of the present invention, in a case of using, as the aqueous developer for a flexographic printing plate used in the above-described development step, a used developer obtained by using the above-described aqueous developer for a flexographic printing plate according to the embodiment of the present invention for one or more developments, it is preferable that the manufacturing method further includes a step of replenishing the above-described aqueous developer for a flexographic printing plate according to the embodiment of the present invention, such that a concentration of components of the above-described photosensitive layer, which have been removed by the development and which is contained in the used developer, is maintained to 7% or less.

### [Use]

The aqueous developer for a flexographic printing plate according to the embodiment of the present invention can be used not only as an aqueous developer for a flexographic printing plate, but also as a washing solution for washing a wall surface of a bathtub of a developing device.

### Examples

Hereinafter, the present invention will be described in more detail with reference to examples. Materials, amounts used, ratios, treatment contents, treatment procedures, and the like shown in the following examples can be appropriately changed without departing from the spirit of the present invention. Therefore, the scope of the present invention should not be construed as being limited by the following examples.

### [Examples 1 to 14 and Comparative Examples 1 to 3]

Each water, alkali agent, surfactant (1), surfactant (2), antifoaming agent, and chelating agent shown in Table 1 below were formulated to have % by mass shown in Table 1 below, thereby preparing aqueous developers.

In Examples 13 and 14, as water formulated in the aqueous developer and water used in the rinse step of development treatment performed in the evaluation of development scum dispersibility, which will be described later, water treated with a water softening device was used.

### [Evaluation]

### <Development scum dispersibility>

A cover film of a flexographic printing plate precursor [FLENEX FW-L2, manufactured by FUJIFILM Corporation] was peeled off, and the flexographic printing plate precursor was exposed with an exposure device in which 15 40 W chemical lamps were arranged for 2 seconds from a substrate side from a distance of 15 cm (back exposure).

Thereafter, with a brush type washing machine (liquid temperature: 50°C) containing each of the prepared aqueous developers, development was performed for an optional time so that the solid content of a development scum (dispersion) was 4.0% by mass or 7.0% by mass. The solid content of the development scum was obtained by measuring 2.0 g of the aqueous developer used (hereinafter, also abbreviated as a "fatigue solution"), drying at 95°C for 18 hours, and calculating solid content% in the fatigue solution from the weight change before and after drying.

Next, 50 cc of the fatigue solution was put into a 1000 cc plastic container containing 450 cc of water in advance, the mixture was stirred and allowed to stand for 12 hours, and aggregates in the liquid were visually observed and evaluated according to the following standard. The results are shown in Table 1 below.

### (Evaluation standard)

A: there were no large aggregates which could be visually identified.
B: slightly large aggregates which could be visually identified were generated.
C: small amount of large aggregates which could be visually identified was generated.
D: large amount of large aggregates which could be visually identified was generated.

### <Brush contamination>

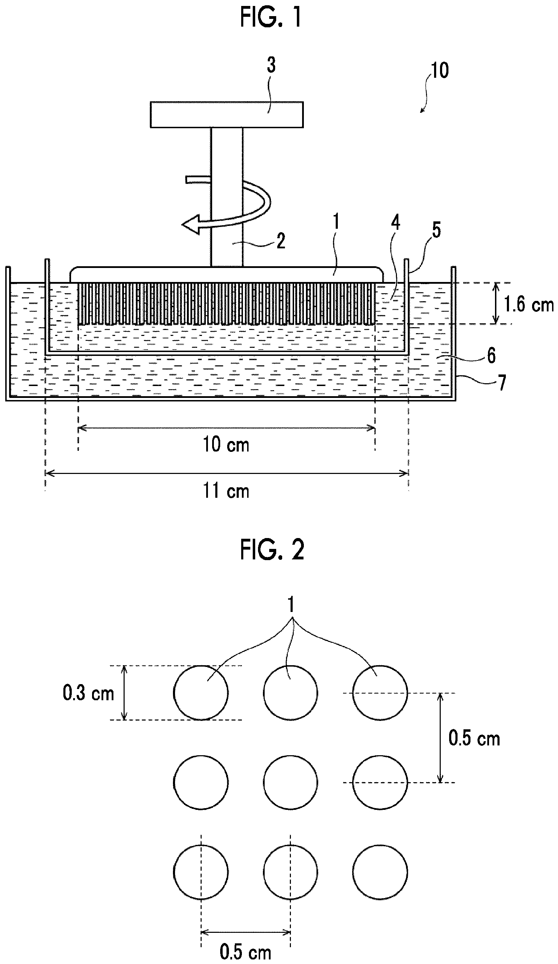

An evaluation device 10 shown in Fig. 1 was used to evaluate the brush contamination.

Specifically, as shown in Fig. 1, a brush 1 was immersed in a fatigue solution container 5 filled with a fatigue solution 4 in a state in which the brush 1 was connected to a motor 3 by a rotation shift 2.

In addition, as shown in Fig. 1, the fatigue solution container 5 was held in a state of being placed in a temperature control container 7 containing hot water at 50°C.

The diameter of brush bristles and the interval between the brush bristles were as shown in Fig. 2.

Evaluation was performed using the above-described evaluation device according to the following procedure.

The brush was rotated at a speed of 150 rpm for 5 minutes.

Next, the rotation was stopped, the brush was pulled up from the fatigue solution, and the brush was allowed to stand for 3 minutes.

Next, adhesion of development scum on a surface of the brush was observed.

The above-described procedure was regarded as one evaluation cycle, and the above-described procedure was repeated.

During the evaluation, since the fatigue solution evaporated and the liquid level was lowered, the fatigue solution was appropriately added to control the liquid level to be 40 cc to 50 cc.

In addition, with regard to the effect of suppressing brush contamination, the number of cycles at which the adhesion of development scum to the brush could be visually observed was evaluated. Therefore, as the number of cycles at which the development scum began to adhere is larger, the effect of suppressing brush contamination is higher.

**[Table 1]**

| | Aqueous developer | | | | | | | | | | Water softening device | | Fatigue solution | Performance | |
|---|---|---|---|---|---|---|---|---|---|---|---|---|---|---|---|
| | Water | | Alkali agent | | Surfactant (1) | | Surfactant (2) | | Antifoaming agent | Chelating agent | | | Concentration of components of photosensitive layer (% by mass) | Development scum dispersibility | Brush contamination (number of cycles) |
| | Type | % by mass | Type | % by mass | Type | % by mass | Type | % by mass | % by mass | % by mass | Presence or absence | Concentration of divalent metal ions | | | |
| Example 1 | Pure water | 98.80 | Sodium carbonate | 0.5 | (1-1) | 0.42 | (2-1) | 0.28 | 0 | 0 | Absence | 50 ppm | 7 | B | 204 |
| Example 2 | Pure water | 98.80 | Sodium carbonate | 0.5 | (1-1) | 0.28 | (2-1) | 0.42 | 0 | 0 | Absence | 50 ppm | 7 | B | 120 |
| Example 3 | Pure water | 98.80 | Sodium carbonate | 0.5 | (1-1) | 0.07 | (2-1) | 0.63 | 0 | 0 | Absence | 50 ppm | 7 | B | 90 |
| Example 4 | Pure water | 98.80 | Sodium carbonate | 0.5 | (1-1) | 0.11 | (2-1) | 0.59 | 0 | 0 | Absence | 50 ppm | 7 | B | 110 |
| Example 5 | Pure water | 98.80 | Sodium carbonate | 0.5 | (1-1) | 0.59 | (2-1) | 0.11 | 0 | 0 | Absence | 50 ppm | 7 | B | 105 |
| Example 6 | Pure water | 98.80 | Sodium carbonate | 0.5 | (1-1) | 0.63 | (2-1) | 0.07 | 0 | 0 | Absence | 50 ppm | 7 | B | 85 |
| Example 7 | Pure water | 98.80 | Sodium carbonate | 0.5 | (1-1) | 0.42 | (2-2) | 0.28 | 0 | 0 | Absence | 50 ppm | 7 | B | 126 |
| Example 8 | Pure water | 98.80 | Sodium carbonate | 0.5 | (1-1) | 0.42 | (2-3) | 0.28 | 0 | 0 | Absence | 50 ppm | 7 | B | 156 |
| Example 9 | Pure water | 98.80 | Sodium carbonate | 0.5 | (1-1) | 0.42 | (2-4) | 0.28 | 0 | 0 | Absence | 50 ppm | 7 | B | 132 |
| Example 10 | Pure water | 98.80 | Sodium carbonate | 0.5 | (1-1) | 0.42 | (2-5) | 0.28 | 0 | 0 | Absence | 50 ppm | 7 | B | 120 |
| Example 11 | Pure water | 98.77 | Sodium carbonate | 0.5 | (1-1) | 0.42 | (2-1) | 0.28 | 0.03 | 0 | Absence | 50 ppm | 7 | B | 300 |
| Example 12 | Pure water | 98.77 | Sodium carbonate | 0.5 | (1-1) | 0.42 | (2-1) | 0.28 | 0.03 | 0.1 | Absence | 50 ppm | 7 | A | 360 |
| Example 13 | Pure water | 98.77 | Sodium carbonate | 0.5 | (1-1) | 0.42 | (2-1) | 0.28 | 0.03 | 0 | Presence | 17 ppm | 7 | A | 360 |
| Example 14 | Pure water | 98.77 | Sodium carbonate | 0.5 | (1-1) | 0.42 | (2-1) | 0.28 | 0.03 | 0 | Presence | 17 ppm | 4 | AA | 408 |
| Comparative Example 1 | Pure water | 99.50 | Sodium carbonate | 0.5 | - | - | - | - | 0 | 0 | Absence | 50 ppm | 4 | C | 24 |
| Comparative Example 2 | Pure water | 98.80 | Sodium carbonate | 0.5 | (1-1) | 0.7 | - | - | 0 | 0 | Absence | 50 ppm | 7 | B | 36 |
| Comparative Example 3 | Pure water | 98.80 | Sodium carbonate | 0.5 | - | - | (2-2) | 0.7 | 0 | 0 | Absence | 50 ppm | 7 | B | 60 |

The following components were used as the components shown in Table 1 above.
· Sodium carbonate: reagent manufactured by FUJIFILM Wako Chemical Corporation
· Surfactant (1-1): polyoxyethylene allylphenyl ether
· Surfactant (2-1): triethanolamine salt of polyoxyethylene allylphenyl ether phosphate
· Surfactant (2-2): ammonium salt of polyoxyethylene allylphenyl ether phosphate
· Surfactant (2-3): polyoxyethylene allylphenyl ether phosphate
· Surfactant (2-4): potassium salt of polyoxyethylene allylphenyl ether phosphate
· Surfactant (2-5): polyoxyethylene allylphenyl ether sulfate
· Antifoaming agent: Fuji AF-A (manufactured by FUJIFILM Corporation)
· Chelating agent: Octaquest E30 (manufactured by Inno Spec specialty chemicals Corporation)

As shown in Table 1 above, in a case where neither the surfactant (1) nor the surfactant (2) was formulated, it was found that the development scum dispersibility was inferior and the brush contamination occurred in 24 cycles (Comparative Example 1).

In addition, in a case of an aqueous developer formulating only one of the surfactant (1) or the surfactant (2), it was found that, although the development scum dispersibility was excellent, there was room for improvement in brush contamination (Comparative Examples 2 and 3).

On the other hand, in a case where both the surfactant (1) and the surfactant (2) were formulated, it was found that excellent development scum dispersibility could be maintained and the brush contamination could be improved (Examples 1 to 14).

In particular, from the comparison of Examples 1 to 6, in a case where the content of the surfactant (1) was more than 15% by mass and less than 85% by mass with respect to the total content of the surfactant (1) and the surfactant (2), it was found that the brush contamination could be further improved.

In addition, from the comparison between Example 1 and Example 11, in a case of formulating the antifoaming agent, it was found that the brush contamination could be further improved.

In addition, from the comparison between Example 11 and Example 12, in a case of formulating the chelating agent, it was found that the development scum dispersibility could be improved and the brush contamination could be further improved.

In addition, from the comparison between Example 11 and Example 13, in a case where the water treated with a water softening device was used as the water formulated in the aqueous developer and the water used in the rinse step, and the concentration of divalent metal ions was 20 ppm or less in terms of calcium carbonate, it was found that the development scum dispersibility could be improved and the brush contamination could be further improved.

In addition, from the comparison between Examples 1 and 7 to 9 and Example 10, in a case where the anionic group represented by R2 in Formula (2) described above was a phosphoric acid group or a phosphoric acid salt group, it was found that the brush contamination could be further improved.

### Explanation of References

1: brush
2: rotation shift
3: motor
4: fatigue solution
5: fatigue solution container
6: hot water
7: temperature control container
10: evaluation device

## Claims

1. An aqueous developer for a flexographic printing plate, comprising:
a surfactant represented by Formula (1);
a surfactant represented by Formula (2); and
water, 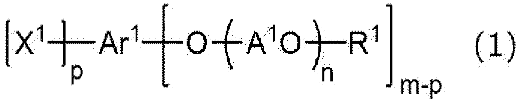 here, in Formula (1),
Ar¹ represents an m-valent aromatic group and m represents an integer of 1 to 8,
X¹ represents a monovalent organic group and p represents an integer of 0 to 3, which is smaller than m, in a case where p is 2 or 3, a plurality of X¹'s may be the same or different from each other,
A¹ represents an alkylene group having 2 to 4 carbon atoms, R¹ represents a hydrogen atom or an alkyl group, and n represents an integer of 1 to 100, in a case where n is an integer of 2 to 100, a plurality of A¹'s may be the same or different from each other, and in a case where m - p is an integer of 2 to 8, a plurality of A¹'s, n's, and R¹'s may all be the same or different from each other, 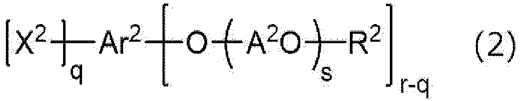 here, in Formula (2),
Ar² represents an r-valent aromatic group and r represents an integer of 1 to 8,
X² represents a monovalent organic group and q represents an integer of 0 to 3, which is smaller than r, in a case where q is 2 or 3, a plurality of X²'s may be the same or different from each other,
A² represents an alkylene group having 2 to 4 carbon atoms, R² represents an anionic group, and s represents an integer of 1 to 100, in a case where s is an integer of 2 to 100, a plurality of A²'s may be the same or different from each other, and in a case where r - q is an integer of 2 to 8, a plurality of A²'s, s's, and R²'s may all be the same or different from each other.

2. The aqueous developer for a flexographic printing plate according to claim 1,
wherein a content of the surfactant represented by Formula (1) is more than 15% by mass and less than 85% by mass with respect to a total content of the surfactant represented by Formula (1) and the surfactant represented by Formula (2).

3. The aqueous developer for a flexographic printing plate according to claim 1 or 2,
wherein the anionic group represented by R² in Formula (2) is an oxoacid group or an oxoacid salt group.

4. The aqueous developer for a flexographic printing plate according to claim 3,
wherein the oxoacid salt group is an ammonium salt, a primary ammonium salt, a secondary ammonium salt, a tertiary ammonium salt, or a quaternary ammonium salt of the oxoacid group.

5. The aqueous developer for a flexographic printing plate according to any one of claims 1 to 4,
wherein the anionic group represented by R² in Formula (2) is a phosphoric acid group or a phosphoric acid salt group.

6. The aqueous developer for a flexographic printing plate according to any one of claims 1 to 5, further comprising:
an alkali agent.

7. The aqueous developer for a flexographic printing plate according to any one of claims 1 to 6, further comprising:
an antifoaming agent.

8. The aqueous developer for a flexographic printing plate according to any one of claims 1 to 7, further comprising:
a chelating agent.

9. The aqueous developer for a flexographic printing plate according to any one of claims 1 to 8,
wherein a concentration of divalent metal ions is 20 ppm or less in terms of calcium carbonate.

10. A manufacturing method of a flexographic printing plate having a non-image area and an image area, the manufacturing method comprising:
an exposure step of imagewise exposing a photosensitive layer in a flexographic printing plate precursor having the photosensitive layer;
a development step of, after the exposure step, performing development using the aqueous developer for a flexographic printing plate according to any one of claims 1 to 9 to form a non-image area and an image area; and
a rinse step of, after the development step, performing rinsing with water.

11. The manufacturing method of a flexographic printing plate according to claim 10,
wherein the water used in the rinse step is water in which a concentration of divalent metal ions is 20 ppm or less in terms of calcium carbonate.

12. The manufacturing method of a flexographic printing plate according to claim 10 or 11,
wherein the aqueous developer for a flexographic printing plate used in the development step is a used developer obtained by using the aqueous developer for a flexographic printing plate according to any one of claims 1 to 9 for one or more developments, and
the manufacturing method further includes a step of replenishing the aqueous developer for a flexographic printing plate according to any one of claims 1 to 9 such that a concentration of components of the photosensitive layer, which have been removed by the development and which is contained in the used developer, is maintained to 7% or less.
